# EUROPEAN PATENT APPLICATION

(11) **EP 4 654 263 A1**
(43) Date of publication of application: **26.11.2025**
(21) Application number: 25174204.5
(22) Date of filing: 05.05.2025
(51) Int. Cl.: H01L 23/66, H01L 25/18

(54) **SYSTEMS AND METHODS USING TWO OR MORE PROCESS TECHNOLOGIES FOR AMPLIFICATION**

(30) Priority: 13.05.2024 US 202463646292 P; 15.10.2024 US 202418915646
(71) Applicant: Avago Technologies International Sales Pte. Limited, Singapore 768923 (SG)
(72) Inventor: Kwon, Dae Hyun, Irvine, CA, 92618 (US); Afsahi, Ali, Irvine, CA, 92618 (US); Behzad, Arya, Irvine, CA, 92618 (US)
(74) Representative: Grünecker Patent- und Rechtsanwälte PartG mbB

(57) **Abstract**

A power amplifier or power amplification technique can achieve improved radio frequency (RF) performance. The power amplifier includes circuitry including a configurable impedance matching circuit and a driver circuit. The driver circuit is fabricated using a first process different than a second process. The impedance matching circuit being fabricated using the second process. Circuits in the first process can be used to partially or in whole control the tuning of the matching circuit in the second process.

## Description

### Cross Reference to Related Patent Applications

This application claims the benefit of and the priority to U.S. Provisional Patent Application No. 63/646,292 filed May 13, 2024, the entire disclosure of which is incorporated by reference herein.

### Field of the Disclosure

This disclosure generally systems and method for power amplifiers including but not limited to hybrid radio frequency (RF) power amplifiers using multiple process technologies that enable higher performance over multi-mode multi-band operations.

### Background of the Disclosure

RF power amplifiers are electronic devices designed to amplify signals in the radio frequency range which generally spans from 20 kilohertz (kHz) to 300 gigahertz (GHz). Generally, RF power amplifiers boost the power of RF signal to levels suitable for transmission over a distance or other criteria associated with radio broadcasting systems, cellular base stations, test and measurement equipment, networks, communications systems, spectrum analyzers and microwave communication. RF power amplifiers are used in a variety of applications including but not limited communication systems (e.g., mobile phones, Wi-Fi devices, Bluetooth (BT) devices, satellite communication systems, near field communication systems, and broadcasting systems), radar systems, medical equipment, military and aerospace systems, and test and measurement equipment.

### Brief Description of the Drawings

Various objects, aspects, features, and advantages of the disclosure will become more apparent and better understood by referring to the detailed description taken in conjunction with the accompanying drawings, in which like reference characters identify corresponding elements throughout. In the drawings, like reference numbers generally indicate identical, functionally similar, and/or structurally similar elements.
FIG. 1A is a block diagram depicting a network environment including one or more access points in communication with one or more devices or stations, according to some embodiments.
FIGS. 1B and 1C are block diagrams depicting computing devices useful in connection with the methods and systems described herein, according to some embodiments.
FIG. 2A is a schematic block diagram of an RF amplifier according to some embodiments.
FIG. 2B is a schematic block diagram of interstage matching circuits for the RF amplifier illustrated in FIG. 2A according to some embodiments.
FIG. 2C is a schematic block diagram of output matching circuits for the RF amplifier illustrated in FIG. 2A according to some embodiments.
FIG. 3 is a schematic block diagram of an RF amplifier according to some embodiments.
FIG. 4 is a schematic block diagram of an RF amplifier according to some embodiments.
FIG. 5 is a schematic block diagram of an RF amplifier according to some embodiments.

The details of various embodiments of the methods and systems of the present solution are set forth in the accompanying drawings and the description below.

### Detailed Description

The following IEEE standard(s), including any draft versions of such standard(s), are hereby incorporated herein by reference in their entirety and are made part of the present disclosure for all purposes: WiFi Alliance standards and IEEE 802.11 standards including but not limited to IEEE 802.11a^{™}, IEEE 802.11b^{™}, IEEE 802.11g^{™}, IEEE P802.11n^{™}; IEEE P802.11ac^{™}; and IEEE P802.11be^{™} through IEEE P802.11bn^{™} standards. Although this disclosure can reference aspects of these standard(s), the disclosure is in no way limited by these standard(s).

For purposes of reading the description of the various embodiments below, the following descriptions of the sections of the specification and their respective contents can be helpful:
- Section A describes a network environment and computing environment which can be useful for practicing embodiments described herein; and
- Section B describes embodiments of systems and methods for implementing hybrid power amplifiers using multiple technologies.

Some embodiments are related to the use of multiple process technologies for RF power amplifiers. The processes are selected to achieve improved RF performances, e.g., higher efficiency and linearity, simultaneous operation over wide frequency range, and/or reconfigurability and/or programmability for various applications and/or requirements in some embodiments. In some embodiments, a hybrid process (e.g., a combination of two or more processes) provides superior RF power amplifier performances in a compact size. Compact and efficient RF power amplifiers are useful for the front-end modules (FEM). Some embodiments relate to hybrid RF power amplifiers using multiple process technologies enabling higher performances over multi-mode multi-band operations. The hybrid power amplifiers can be used in IEEE 802.11 devices.

In some embodiments, different process technologies are selected which are suitable for different aspects of power amplifier design. As an example, a first process, such as, a GaAs process or an SiGe Heterojunction Bipolar Transistors (HBTs) process, has superior RF characteristics while lacking good RF switches and logic implementation. On the other hand, a second process, such as, an RF Silicon-On-Insulator (SOI) process or Metal-Oxide-Semiconductor Field-Effect-Transistor (MOSFET) process lacks high performance RF devices, but provides good switches and logic implementation for programmability. Some embodiments of the systems and methods disclosed herein avoid suboptimal designs associated with the use of one technology for RF power amplifier (PA) designs.

Some embodiments relate to a power amplifier (PA) and/or method of making a power amplifier. The PA includes circuitry inclduing a first die with amplification circuitry fabricated using a first integrated circuit (IC) process and a second die with amplification circuitry fabricated using a second IC process. The circuitry is provided in a single package or module, and the amplification circuitry fabricated using the first integrated circuit (IC) process is couped to the amplification circuitry fabricated using the second integrated circuit (IC) process using a plurality of connections within the single package or module.

In some embodiments, the connections are die-to-die connections. Die-to-die connections refer to connections that are made directly from one die to the other die without an intervening circuit (e.g., by bond wires or direct pad/solder ball connection) in some embodiments. In some embodiments, the connections include an interstage connection. An interstage connection refers to a connection occurring at a place in the amplification circuitry between stages of the amplifier in some embodiments. For example, such stages can be a first power amplifier stage and a second power amplifier stage on one of the die.

Some embodiments relate to a power amplifier (PA). The PA includes circuitry including a first die with amplification circuitry fabricated using in a first integrated circuit (IC) process and a second die with amplification circuitry fabricated using a second IC process. Amplification circuitry refers to any type of circuit involved in amplification of a signal. Amplification circuitry can include any type of amplifier (e.g., power amplifier, driver stage, preamplifier or associated matching circuits used in the amplification of a signal) in some embodiments. A matching circuit refers to an impedance matching circuit in some embodiments. Integrated refers the disposition of the components in a same product in some embodiments. The integration can occur using to the fabrication of a component using a same process or partially using a same process in some embodiments. The same product can be a module, a die, a package, a printed circuit board in some embodiments. For example, the product can be a power amplifier.

Some embodiments relate to a method. The method includes providing an RF signal to a second die with amplification circuitry fabricated in a second integrated circuit (IC) process and providing the RF signal to a first die with amplification circuitry fabricated in a first integrated circuit (IC) process.

Some embodiments relate to a power amplifier. The power amplifier includes circuitry including a configurable impedance matching circuit and a driver circuit. The driver circuit is fabricated using a first process different than a second process. The impedance matching circuit is fabricated using the second process. A driver circuit refers to a transistor based circuit configured to amplify a signal for a load in some embodiments. The driver circuit or combinations thereof are generally responsible for a substantial portion of the gain. Process refers to sequence of operations for performing a task (e.g., for semiconductor fabrication, semiconductor manufacturing, etc.) in some embodiments. The operations can be specific to types of wafer, integrated circuits, transistors, and/or other types of integrate circuit (IC) structures. Processes can be categorized based on various factors, including the type of device being manufactured, the feature size, the materials used, and the specific technologies employed (e.g., planar process, metal oxide semiconductor field effect transistor (MOSFET) process, complementary MOSFET process, germanium silicon process, silicon on glass process, bipolar process, silicon carbide process, gallium arsenide process, heterojunction transistor process, bipolar/COMOS process, fin field effect transistor (FinFET) Gallium Nitride process, a three dimensional process, etc.).

An impedance matching circuit refers to a circuit configured to cause an impedance of an input match an impedance of an output some embodiments. An impedance matching circuit can be an input impedance matching circuit, an interstage impedance matching circuit or an output matching circuit. An input impedance matching circuit is an impedance matching circuit disposed at an input of a device or circuit and is configured to perform matching related to the input of the device (e.g., an RF signal input) or circuit. An interstage impedance matching circuit is an impedance matching circuit disposed between stages of a circuit and configured to perform matching related to the stages of a device or circuit (e.g., between driver stages, preamplifier stages, and combinations thereof). An output impedance matching circuit is an impedance matching circuit disposed at an output of a device circuit and configured to perform matching related to the output of the device or circuit (e.g., an RF signal output).

In some embodiments, the power amplifier is a radio frequency (RF) amplifier. An RF amplifier refers to an amplifier configured to provide amplified RF signals in some embodiments.

In some embodiments, the driver circuit is provided on a first die and the impedance matching circuit is provided on a second die. In some embodiments, the first die includes a bias circuit and the driver circuit, and the second die includes a current source for the bias circuit. A bias circuit or bias circuitry refers to a circuit configured to bias another circuit to make adjustments in its performance in some embodiments. The bias circuit can adjust power, current or voltage to certain IC structures in some embodiments. A current source is a circuit configured to provide a current at a particular magnitude in some embodiments.

In some embodiments, the first die and second die are provided in a multichip module. In some embodiments, the impedance matching circuit is an input matching circuit, an interstage matching circuit or an output matching circuit. In some embodiments, the power amplifier includes an output matching circuit disposed on a printed circuit board. A printed circuit board refers to a structure with conductive lines or traces and pads which houses IC die or IC packages in some embodiments.

In some embodiments, an output matching circuit is disposed on the first die. In some embodiments, an output matching circuit is disposed on the second die and directly coupled to the driver circuit on the first die.

Some embodiments relate to a multichip module. The multichip module includes a first die including configurable impedance matching circuit and a second die including a driver circuit. The driver circuit is fabricated using a first process different than a second process, and the impedance matching circuit is fabricated using the second process. A configurable impedance matching circuit refers to an impedance matching circuit that can have its matching characteristics adjusted.

In some embodiments, the first process is a gallium arsenide or silicon germanium process and the second process is a complementary metal oxide semiconductor process. A gallium arsenide process refers to a process that provides IC devices on a gallium arsenide containing substrate or layer in some embodiments. A silicon germanium process refers to a process that provides IC devices on a silicon germanium containing substrate or layer in some embodiments. A complementary metal oxide semiconductor process refers to a process the provides NMOS and PMOS transistors on substrate or layer in some embodiments.

In some embodiments, the driver circuit includes a first stage and a second stage. A first interstage impedance matching circuit is coupled between the first stage and the second stage and is disposed on the first die. In some embodiments, the first interstage impedance matching circuit is a fixed circuit. A fixed circuit refers to non-configurable circuit in some embodiments.

In some embodiments, the multichip module includes a pair of second interstage impedance matching circuits disposed on the second die. The first stage is disposed between the pair of the second interstage impedance matching circuits.

In some embodiments, the first die includes bias circuitry, and the second die includes a current source for the bias circuitry. In some embodiments, the multichip module includes an output impedance matching circuit disposed on the first die.

Some embodiments relate to a method. The method includes providing an RF signal to a first impedance matching circuit on a first die, and providing the RF signal to a second impedance matching circuit on a first die. The first die is fabricated using a first process, and the second die is fabricated using a second process. The method also includes providing the RF signal to a first output coupled to a third impedance matching circuit disposed on the first die and a fourth impedance matching circuit disposed on the second die.

In some embodiments, the method includes providing the RF signal to a second driver circuit on the second die. In some embodiments, the method includes providing the RF signal to a fifth impedance matching circuit on the second die, on a printed circuit board, on an interposer, or on a package substrate. In some embodiments, the method of includes providing the RF signal to a sixth impedance matching circuit on the first die.

### A. Computing and Network Environment

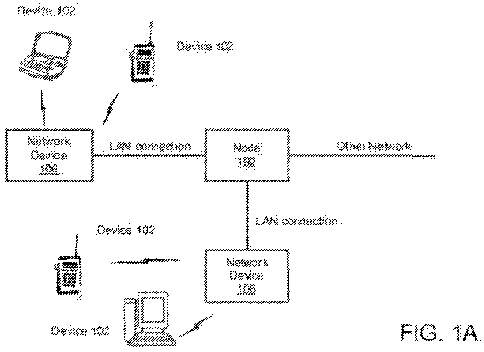

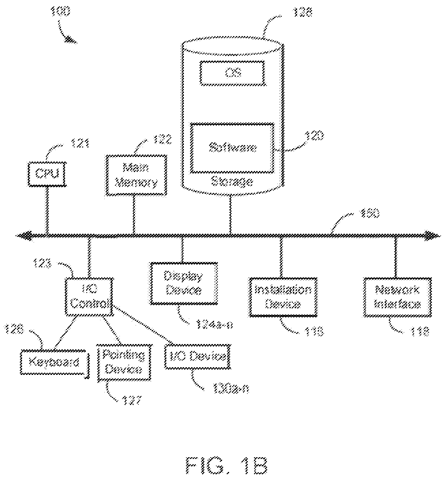

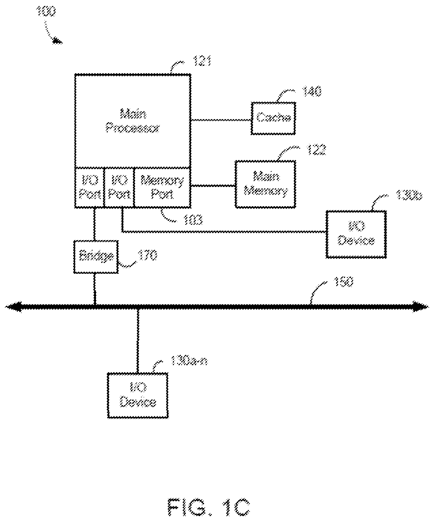

Prior to discussing specific embodiments of the present solution, it can be helpful to describe aspects of the operating environment as well as associated system components (e.g., hardware elements) in connection with the methods and systems described herein. Referring to FIG. 1A, an embodiment of a network environment is depicted. In brief overview, the network environment includes a wireless communication system that includes one or more access points (APs) or network devices 106, one or more stations or wireless communication devices 102 and a network hardware component or network hardware 192. The wireless communication devices 102 can for example include laptop computers, tablets, personal computers, and/or cellular telephone devices. The details of an embodiment of each station or wireless communication device 102 and AP or network device 106 are described in greater detail with reference to FIGS. 1B and 1C. The network environment can be an ad hoc network environment, an infrastructure wireless network environment, a subnet environment, etc. in one embodiment. The network devices 106 or APs can be operably coupled to the network hardware 192 via local area network connections. Network devices 106 are 5G base stations in some embodiments. The network hardware 192, which can include a router, gateway, switch, bridge, modem, system controller, appliance, etc., can provide a local area network connection for the communication system. Each of the network devices 106 or APs can have an associated antenna or an antenna array to communicate with the wireless communication devices in its area. The wireless communication devices 102 can register with a particular network device 106 or AP to receive services from the communication system (e.g., via a SU-MIMO or MU-MIMO configuration). For direct connections (e.g., point-to-point communications), some wireless communication devices can communicate directly via an allocated channel and communications protocol. Some of the wireless communication devices 102 can be mobile or relatively static with respect to network device 106 or AP.

In some embodiments, a network device 106 or AP includes a device or module (including a combination of hardware and software) that allows wireless communication devices 102 to connect to a wired network using wireless-fidelity (WiFi), or other standards. A network device 106 or AP can sometimes be referred to as a wireless access point (WAP). A network device 106 or AP can be implemented (e.g., configured, designed and/or built) for operating in a wireless local area network (WLAN). A network device 106 or AP can connect to a router (e.g., via a wired network) as a standalone device in some embodiments. In other embodiments, network device 106 or AP can be a component of a router. Network device 106 or AP can provide multiple devices access to a network. Network device 106 or AP can, for example, connect to a wired Ethernet connection and provide wireless connections using radio frequency links for other devices 102 to utilize that wired connection. A network device 106 or AP can be implemented to support a standard for sending and receiving data using one or more radio frequencies. Those standards, and the frequencies they use can be defined by the IEEE (e.g., IEEE 802.11 standards). A network device 106 or AP can be configured and/or used to support public Internet hotspots, and/or on a network to extend the network's Wi-Fi signal range.

In some embodiments, the access points or network devices 106 can be used for (e.g., in-home, in-vehicle, or in-building) wireless networks (e.g., IEEE 802.11, Bluetooth, ZigBee, any other type of radio frequency based network protocol and/or variations thereof). Each of the wireless communication devices 102 can include a built-in radio and/or is coupled to a radio. Such wireless communication devices 102 and /or access points or network devices 106 can operate in accordance with the various aspects of the disclosure as presented herein to enhance performance, reduce costs and/or size, and/or enhance broadband applications. Each wireless communication device 102 can have the capacity to function as a client node seeking access to resources (e.g., data, and connection to networked nodes such as servers) via one or more access points or network devices 106.

The network connections can include any type and/or form of network and can include any of the following: a point-to-point network, a broadcast network, a telecommunications network, a data communication network, a computer network. The topology of the network can be a bus, star, or ring network topology. The network can be of any such network topology as known to those ordinarily skilled in the art capable of supporting the operations described herein. In some embodiments, different types of data can be transmitted via different protocols. In other embodiments, the same types of data can be transmitted via different protocols.

The communications device(s) 102 and access point(s) or network devices 106 can be deployed as and/or executed on any type and form of computing device, such as a computer, network device or appliance capable of communicating on any type and form of network and performing the operations described herein. FIGS. 1B and 1C depict block diagrams of a computing device 100 useful for practicing an embodiment of the wireless communication devices 102 or network device 106. As shown in FIGS. 1B and 1C, each computing device 100 includes a processor 121 (e.g., central processing unit), and a main memory unit 122. As shown in FIG. 1B, a computing device 100 can include a storage device 128, an installation device 116, a network interface 118, an I/O controller 123, display devices 124a-124n, a keyboard 126 and a pointing device 127, such as a mouse. The storage device 128 can include an operating system and/or software. As shown in FIG. 1C, each computing device 100 can also include additional optional elements, such as a memory port 103, a bridge 170, one or more input/output devices 130a-130n, and a cache memory 140 in communication with the central processing unit or processor 121.

The central processing unit or processor 121 is any logic circuitry that responds to and processes instructions fetched from the main memory unit 122. In many embodiments, the central processing unit or processor 121 is provided by a microprocessor unit, such as: those manufactured by Intel Corporation of Santa Clara, California; those manufactured by International Business Machines of White Plains, New York; or those manufactured by Advanced Micro Devices of Sunnyvale, California. The computing device 100 can be based on any of these processors, or any other processor capable of operating as described herein.

Main memory unit 122 can be one or more memory chips capable of storing data and allowing any storage location to be directly accessed by the microprocessor or processor 121, such as any type or variant of Static random access memory (SRAM), Dynamic random access memory (DRAM), Ferroelectric RAM (FRAM), NAND Flash, NOR Flash and Solid State Drives (SSD). The main memory unit 122 can be based on any of the above described memory chips, or any other available memory chips capable of operating as described herein. In the embodiment shown in FIG. 1B, the processor 121 communicates with main memory unit 122 via a system bus 150 (described in more detail below). FIG. 1C depicts an embodiment of a computing device 100 in which the processor communicates directly with main memory unit 122 via a memory port 103. For example, in FIG. 1C the main memory unit 122 can be DRDRAM.

FIG. 1C depicts an embodiment in which the main processor 121 communicates directly with cache memory 140 via a secondary bus, sometimes referred to as a backside bus. In other embodiments, the main processor 121 communicates with cache memory 140 using the system bus 150. Cache memory 140 typically has a faster response time than main memory unit 122 and is provided by, for example, SRAM, BSRAM, or EDRAM. In the embodiment shown in FIG. 1C, the processor 121 communicates with various I/O devices 130 via a local system bus 150. Various buses can be used to connect the central processing unit or processor 121 to any of the I/O devices 130, for example, a VESA VL bus, an ISA bus, an EISA bus, a MicroChannel Architecture (MCA) bus, a PCI bus, a PCI-X bus, a PCI-Express bus, or a NuBus. For embodiments in which the I/O device is a video display 124, the processor 121 can use an Advanced Graphics Port (AGP) to communicate with the display 124. FIG. 1C depicts an embodiment of a computer or computer system100 in which the main processor 121 can communicate directly with I/O device 130b, for example via HYPERTRANSPORT, RAPIDIO, or INFINIBAND communications technology. FIG. 1C also depicts an embodiment in which local busses and direct communication are mixed: the processor 121 communicates with I/O device 130a using a local interconnect bus while communicating with I/O device 130b directly.

A wide variety of I/O devices 130a-130n can be present in the computing device 100. Input devices include keyboards, mice, trackpads, trackballs, microphones, dials, touch pads, touch screen, and drawing tablets. Output devices include video displays, speakers, inkjet printers, laser printers, projectors and dye-sublimation printers. The I/O devices can be controlled by an I/O controller 123 as shown in FIG. 1B. The I/O controller can control one or more I/O devices such as a keyboard 126 and a pointing device 127, e.g., a mouse or optical pen. Furthermore, an I/O device can also provide storage and/or an installation medium for the computing device 100. In still other embodiments, the computing device 100 can provide USB connections (not shown) to receive handheld USB storage devices such as the USB Flash Drive line of devices manufactured by Twintech Industry, Inc. of Los Alamitos, California.

Referring again to FIG. 1B, the computing device 100 can support any suitable installation device 116, such as a disk drive, a CD-ROM drive, a CD-R/RW drive, a DVD-ROM drive, a flash memory drive, tape drives of various formats, USB device, hard-drive, a network interface, or any other device suitable for installing software and programs. The computing device 100 can further include a storage device, such as one or more hard disk drives or redundant arrays of independent disks, for storing an operating system and other related software, and for storing application software programs such as any program or software 120 for implementing (e.g., configured and/or designed for) the systems and methods described herein. Optionally, any of the installation devices 116 could also be used as the storage device. Additionally, the operating system and the software can be run from a bootable medium.

Furthermore, the computing device 100 can include a network interface 118 to interface to a network through a variety of connections including, but not limited to, standard telephone lines, LAN or WAN links (e.g., 802.11, T1, T3, 56kb, X.25, SNA, DECNET), broadband connections (e.g., ISDN, Frame Relay, ATM, Gigabit Ethernet, Ethernet-over-SONET), wireless connections, or some combination of any or all of the above. Connections can be established using a variety of communication protocols (e.g., TCP/IP, IPX, SPX, NetBIOS, Ethernet, ARCNET, SONET, SDH, Fiber Distributed Data Interface (FDDI), RS232, IEEE 802.11, IEEE 802.11a, IEEE 802.11b, IEEE 802.11g, IEEE 802.11n, IEEE 802.11ac, IEEE 802.11ad, CDMA, GSM, WiMax and direct asynchronous connections). In one embodiment, the computing device 100 communicates with other computing devices 100' via any type and/or form of gateway or tunneling protocol such as Secure Socket Layer (SSL) or Transport Layer Security (TLS). The network interface 118 can include a built-in network adapter, network interface card, PCMCIA network card, card bus network adapter, wireless network adapter, USB network adapter, modem or any other device suitable for interfacing the computing device 100 to any type of network capable of communication and performing the operations described herein.

In some embodiments, the computing device 100 can include or be connected to one or more display devices 124a-124n. As such, any of the I/O devices 130a-130n and/or the I/O controller 123 can include any type and/or form of suitable hardware, software, or combination of hardware and software to support, enable or provide for the connection and use of the display device(s) 124a-124n by the computing device 100. For example, the computing device 100 can include any type and/or form of video adapter, video card, driver, and/or library to interface, communicate, connect or otherwise use the display device(s) 124a-124n. In one embodiment, a video adapter can include multiple connectors to interface to the display device(s) 124a-124n. In other embodiments, the computing device 100 can include multiple video adapters, with each video adapter connected to the display device(s) 124a-124n. In some embodiments, any portion of the operating system of the computing device 100 can be configured for using multiple display devices 124a-124n. In further embodiments, an I/O device 130 can be a bridge between the system bus 150 and an external communication bus, such as a USB bus, an Apple Desktop Bus, an RS-232 serial connection, a SCSI bus, a FireWire bus, a FireWire 800 bus, an Ethernet bus, an AppleTalk bus, a Gigabit Ethernet bus, an Asynchronous Transfer Mode bus, a FibreChannel bus, a fiber optic bus, a Serial Attached small computer system interface bus, a USB connection, or a HDMI bus.

A computing device 100 of the sort depicted in FIGS. 1B and 1C can operate under the control of an operating system, which controls scheduling of tasks and access to system resources. The computing device 100 can be running any operating system such as any of the versions of the MICROSOFT WINDOWS operating systems, the different releases of the Unix and Linux operating systems, any version of the MAC OS for Macintosh computers, any embedded operating system, any real-time operating system, any open source operating system, any proprietary operating system, any operating systems for mobile computing devices, or any other operating system capable of running on the computing device and performing the operations described herein. Typical operating systems include, but are not limited to: Android, produced by Google Inc.; WINDOWS 7, 8 and 10, produced by Microsoft Corporation of Redmond, Washington; MAC OS, produced by Apple Computer of Cupertino, California; WebOS, produced by Research In Motion (RIM); OS/2, produced by International Business Machines of Armonk, New York; and Linux, a freely-available operating system distributed by Caldera Corp. of Salt Lake City, Utah, or any type and/or form of a Unix operating system, among others.

The computer system or computing device 100 can be any workstation, telephone, desktop computer, laptop or notebook computer, server, handheld computer, mobile telephone or other portable telecommunications device, media playing device, a gaming system, mobile computing device, or any other type and/or form of computing, telecommunications or media device that is capable of communication. In some embodiments, the computing device 100 can have different processors, operating systems, and input devices consistent with the device. For example, in one embodiment, the computing device 100 is a smart phone, mobile device, tablet or personal digital assistant. Moreover, the computing device 100 can be any workstation, desktop computer, laptop or notebook computer, server, handheld computer, mobile telephone, any other computer, or other form of computing or telecommunications device that is capable of communication and that has sufficient processor power and memory capacity to perform the operations described herein.

Aspects of the operating environments and components described above will become apparent in the context of the systems and methods disclosed herein.

### B. Systems and Methods For Implementing Hybrid Power Amplifiers Using Two or More Process Technologies.

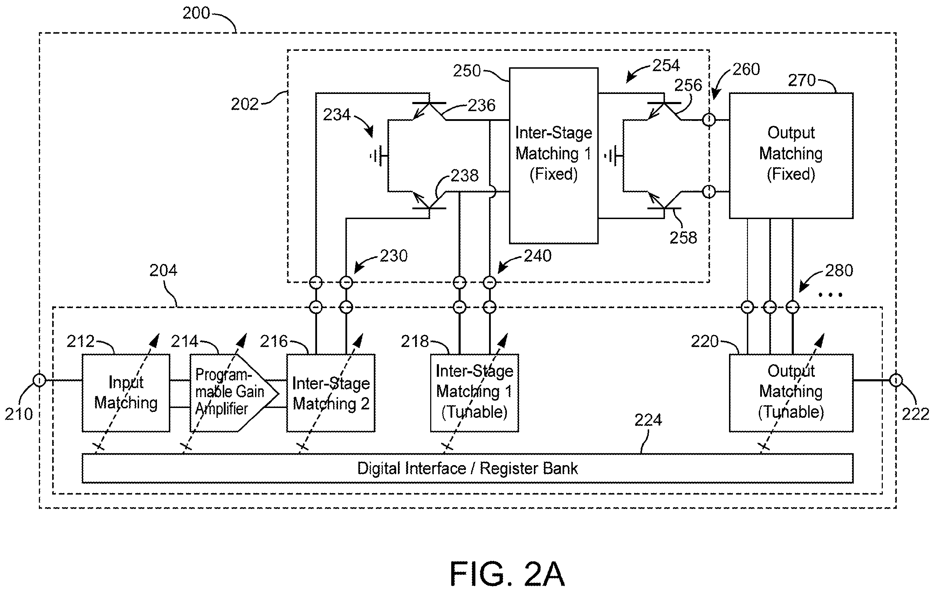

With reference to FIGS. 2A-5, RF amplifiers 200, 300, 400, and 500 use different process technologies that are suitable for different aspects of power amplifier design. RF amplifiers 200, 300, 400, and 500 are configured as RF amplifiers with RF tuning capability in some embodiments. In some embodiments, RF amplifiers 200, 300, 400, and 500 are provided in multichip modules or IC packages and utilized with or within any of the devices or products discussed above with respect to FIGS. 1A-C.

As an example, a first process, referred to as Process 1 herein, such as a GaAs or SiGe Heterojunction Bipolar Transistors (HBTs) process has superior RF characteristics while lacking good RF switching functionality and logic implementation in some embodiments. On the other hand, a second process, refer to Process 2 herein, such as, a Silicon-On-Insulator (SOI) or Metal-Oxide-Semiconductor Field-Effect-Transistor

(MOSFET) process lacks high performance RF devices, but provides good switching functionality and logic implementation for programmability in some embodiments. Process 2 provides circuits for the tunability in the RF matching networks and bias circuits of amplifier stages in circuits provided by Process 1 in some embodiments. This enables both high efficiency by using the Process 1 transistors and reconfigurability (frequency, load impedance, bias currents, gain, etc.) using the Process 2 switches in some embodiments. Thus, in some embodiments, a single power amplifier (PA) such as one of amplifiers 200, 300, 400, or 500 can provide higher or high performances and higher or high efficiency over wide frequency range, and can be reconfigured for various requirements depending on modes and applications. In some embodiments, amplifiers 200, 300, 400, or 500 include RF interstage matching circuits, PA output matching circuits, and bias schemes which use IC elements using Process 1 and Process 2.

In some embodiments, RF routings associated with amplifiers 200, 300, 400, or 500 may travel between two or more process dies. In some embodiments, RF routings in a module (or printed circuit board (PCB)) may be tailored to be a part of the RF matching networks. In some embodiments, the implementation of amplifiers 200, 300, 400, or 500 place two dies as close as possible to minimize the loss from the RF routings. For example, bumps in two dies are placed taken into consideration the complete on-die and module/PCB routes. Direct inter chip connections can be utilized in the multichip module (e.g., using an interposer or other structure) in some embodiments. Wire connections can also be utilized.

In some embodiments, amplifiers 200, 300, 400, or 500 include single- or multiple-stage programmable gain amplifiers on the Process 2 die to provide the gain programmability. This can provide wide gain range control for different modes and applications in some embodiments. In some embodiments, amplifiers 200, 300, 400, and 500 are configured as an attenuator. A power amplifier can refer to a circuit configured to increase or maintain power of a signal in some embodiments. An RF power amplifier can refer to a circuit configured to increase or maintain a power of an RF signal in some embodiments. An attenuator can refer to a circuit configured to decrease power of a signal in some embodiments.

In some embodiments, the logic implementation in Process 2 enables reconfigurability of power amplifier matching networks and bias circuits. For example, register settings can change frequency tuning, bias, gain etc. over frequencies and/or mode of operations. This reconfigurability enables the performance-efficiency tradeoff control for tuning or optimizing settings in or for different applications in some embodiments.

Referring to FIG. 2A, RF amplifier 200 includes a circuit 202 provided using Process 1 and a circuit 204 provided using Process 2. Circuit 202 can be provided on its own die, and circuit 204 can be provided on its own die (e.g., separate from the die of circuit 202). Circuits 202 and 204 can be provided in an IC package, such as, a multichip module, in some embodiments.

The circuitry of RF amplifier 200 is a hybrid power amplifier with RF tuning (e.g., output matching) on the module or printed circuit board associated with the device. The multichip module can include a printed circuit board for housing circuits (e.g., IC die and discrete components) and providing interconnections between circuits 202 and 204. In some embodiments, RF amplifier 200 includes an output matching circuit 270 which is not part of circuit 202 and 204 and is provided using discrete components provided outside of the Processes 1 and 2 used for circuit 202 and 204, respectively. Output matching circuit 270 can be provided on a printed circuit board or an interposer associated with the multichip module in some embodiments.

Circuit 204 includes an input 210, an input matching circuit 212, a programmable gain amplifier circuit 214, an interstage matching circuit 216, an interstage matching circuit 218, an output matching circuit 220, an output 222 and an interface 224. Input matching circuit 212, a programmable gain amplifier circuit 214, interstage matching circuit 216, interstage matching circuit 218, output matching circuit 220, and an interface 224 are fabricated using Process 2. Input 210 receives an RF signal and is coupled to input matching circuit 212.

Circuit 202 is couped to an input 230, an output 240 and an output 260. Circuit 202 includes a driver circuit 234, an interstage matching circuit 250, and a driver circuit 254. Driver circuit 254 is coupled output matching circuit 270 at output 260. Output matching circuit 270 is coupled to output 280 and output matching circuit 220 of circuit 204. Driver circuit 234, interstage matching circuit 250, and driver circuit 254 are fabricated using Process 1. A single driver circuit 234 or 236 can be used in some embodiments. More than two driver circuits 234 or 236 can be utilized in some embodiments.

Input matching circuit 212 is a circuit configured for performing input matching for amplifier 200. Circuit 212 can include a network of passive components (e.g., resistors, inductors, capacitors, or transmission lines) configured to ensure that the impedance of input 210 of amplifier 200 matches the impedance of the source signal. Circuit 212 is configured to provide impedance matching to maximizing power transfer, minimizing signal reflections, and ensuring the amplifier 200 operates efficiently and effectively in some embodiments. Circuit 212 is configured as an L network, π network, T network, a transformer, a stub matching network, a capacitive network, a resistive-capacitive network, etc. Variable capacitance and resistance circuits can be used to provide impedance configurability in some embodiments. Switches (CMOS switches) can be used to select configurations in some embodiments. Circuit 212 is configurable or programmable using control signals from interface 224. Circuit 212 is coupled to programmable gain control circuit 214.

Interface 224 includes a register bank and interconnections to provide control signals to circuits 212, 214, 216, 218, and 220. The control signals can control switches in circuits 212, 214, 216, 218, and 220 (e.g., for impedance matching and gain control operations). The control signals can be selected in response to selected frequencies, feedback, etc. Data for the control signals can be stored in registers in interface 224.

Programmable gain amplifier circuit 214 amplifies or attenuates the signal received from circuit 212 and provides the amplified or attenuated signal to circuit 216. Programmable gain amplifier circuit 214 includes one or more amplifiers. The one or more amplifiers have a gain (the ratio of output signal to input signal) that can be adjusted or programmed. The amplifiers can be variable transconductance amplifiers. Programmable gain amplifier circuit 214 can be configured for precise control over the amplification level, which can be dynamically adjusted based on the requirements of the application. The gain adjustment can be controlled through signals from interface 224.

Interstage matching circuit 216 is similar to input matching circuit 212 and can include similar components. Interstage matching circuit 216 can include a network of passive components (such as inductors, capacitors, resistors, or transmission lines) placed between programmable gain amplifier circuit 214 and circuit 202 to optimize the transfer of signals between those stages in some embodiments. Interstage matching circuit 216 is configured to match the impedance of the output of programmable gain amplifier circuit 214 to an input 230 of circuit 202. Interstage matching circuit 216 is configured to maximizing power transfer, minimizing signal reflections, and maintaining signal integrity in some embodiments. Circuit 216 is configurable or programmable using control signals from interface 224. Variable capacitance and resistance circuits can be used to provide impedance configurability in some embodiments. Switches (CMOS switches) can be used to select configurations in some embodiments.

Input 230 is coupled to a driver circuit 234 of circuit 202. Driver circuit 234 is a power amplifier driver circuit in some embodiments. Driver circuit 234 can be any type of amplifier driver stage circuit in some embodiments. Driver circuit 234 includes a transistor 236 and a transistor 238 formed using Process 2. Transistors 236 and 238 can be any type of transistors suitable for RF power amplification in some embodiments. In some embodiments, transistors are heterojunction bipolar transistors including a base, collector and emitter coupled in parallel for amplification. The bases of transistors 236 and 238 are coupled to input 230 and amplify the signal at input 230 for reception at output 240 . Output 240 is coupled to interstage matching circuit 250 of circuit 204 and interstage matching circuit 218 of circuit 202.

Interstage matching circuit 250 can include a network of passive components (such as inductors, capacitors, resistors, or transmission lines) placed between driver circuit 234 and 254 to optimize the transfer of signals between driver circuits 234 and 254 (e.g., driver stages) in some embodiments. Interstage matching circuit 250 is configured to match the impedance of the output 240 of driver circuit 234 to an input of drive circuit 254. Interstage matching circuit 216 is configured to maximizing power transfer, minimizing signal reflections, and maintaining signal integrity and is a fixed circuit in some embodiments. Interstage matching circuit 216 is non-configurable or fixed and does not include switching transistors for selecting configurations in contrast to circuit 212, 216, 218, and 330 in some embodiments.

Interstage matching circuit 218 is coupled to output 240 and is similar to matching circuit 216 and can include similar components. Interstage matching circuit 218 can include a network of passive components (such as inductors, capacitors, resistors, or transmission lines) and works with matching circuit 250 of circuit 202 to provide impedance matching for driver circuits 234 and 254 in some embodiments. Interstage matching circuits 218 and 250 are configured to maximizing power transfer, minimizing signal reflections, and maintaining signal integrity in some embodiments. Circuit 218 is configurable or programmable using control signals from interface 224. Variable capacitance and resistance circuits can be used to provide impedance configurability in some embodiments. Switches (CMOS switches) can be used to select configurations in some embodiments.

Driver circuit 254 is similar to driver circuit 234 of circuit 202. Driver circuit 254 is a power amplifier driver circuit in some embodiments. Driver circuit 254 can be any type of amplifier driver stage circuit in some embodiments. Driver circuit 254 includes a transistor 256 and a transistor 258 formed using Process 2. Transistors 256 and 258 can be any type of transistors suitable for RF power amplification in some embodiments. In some embodiments, transistors are heterojunction bipolar transistors including a base, collector and emitter coupled in parallel for amplification. The bases of transistors 256 and 258 are coupled to an output of matching circuit 250 and amplify the signal for reception at output 280. Output 240 is coupled to output matching circuit 270 which is not part of circuits 202 and 204 in some embodiments.

Output matching circuit 270 can include a network of passive components (such as inductors, capacitors, resistors, or transmission lines) placed between output 260 and output 280 to optimize the transfer of signals between those stages in some embodiments. Output matching circuit 270 is configured to match the impedance of the output 260 of driver circuit 254 to output 280. Output matching circuit 270 is configured to maximizing power transfer, minimizing signal reflections, and maintaining signal integrity and is a fixed circuit in some embodiments. Output matching circuit 270 is non-configurable or fixed and does not include switching transistors for selecting configurations in contrast to circuit 212, 216, 218, and 330 in some embodiments.

Output matching circuit 220 of circuit 204 is coupled to output 280 and is similar to matching circuit 218 and can include similar components. Output matching circuit 220 can include a network of passive components (such as inductors, capacitors, resistors, or transmission lines) and works with matching circuit 270 of circuit 202 to provide impedance matching for output 222 in some embodiments. Output matching circuits 220 and 270 are configured to maximizing power transfer, minimizing signal reflections, and maintaining signal integrity in some embodiments. Circuit 220 is configurable or programmable using control signals from interface 224. Variable capacitance and resistance circuits can be used to provide impedance configurability in some embodiments. Switches (CMOS switches) can be used to select configurations in some embodiments.

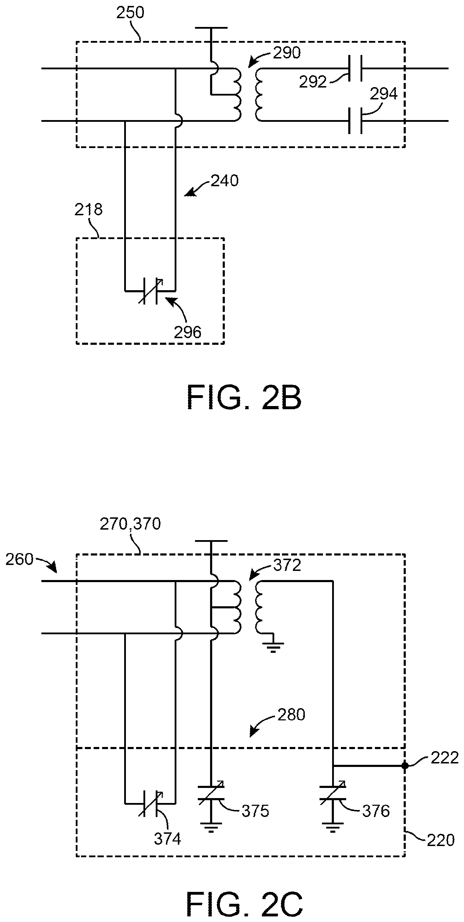

With reference to FIG. 2B, interstage matching circuit 250 can include a transformer network configured for impedance matching. Circuit 250 includes a transformer 290 and a pair of output capacitors 292 and 294 in some embodiments. Interstage matching circuit 218 is coupled to circuit 250 at output 240 and includes a variable capacitor 296 that can be programmed via interface 224 (FIG. 2A). The connections for output 240 can be made by interposer traces, module traces, or printed circuit board traces. In some embodiments, the routings or traces on the module, interposer, or printed circuit board (PCB) can be tailored to be a part of the RF matching networks and are as small as possible to minimize the loss from the RF routings. For example, the connections can be made using solder bumps on each die placed close together.

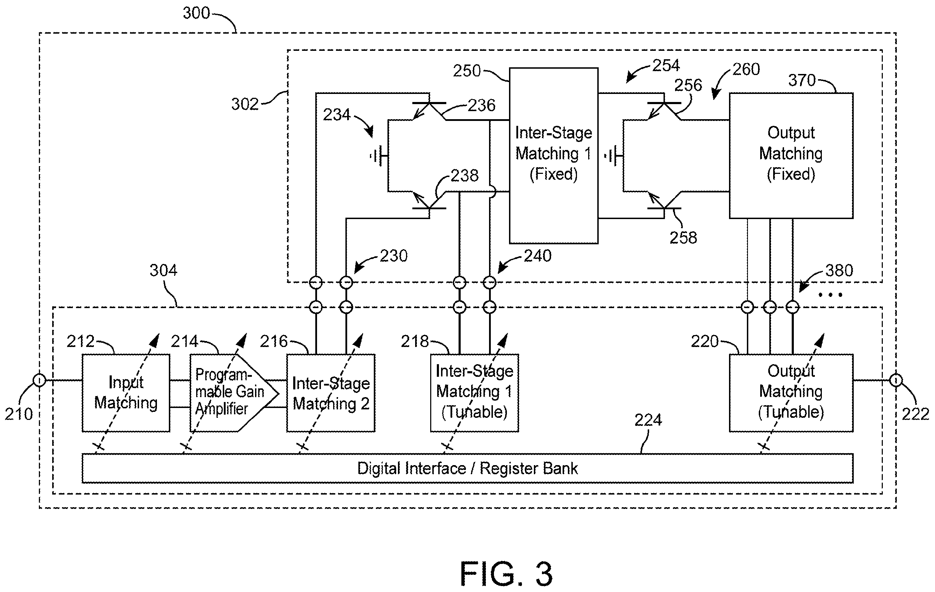

With reference to FIG. 2C, output matching circuit 270 (or output matching circuit 370 discussed below with reference to FIG. 3) can include a transformer network configured for impedance matching. Circuit 270 includes a transformer 372. Output matching circuit 220 is couped to circuit 270 at output 280 and includes variable capacitors 374, 375, and 376 that can be programmed via interface 224 (FIG. 2A). The connections for output 280 can be made by interposer traces, module traces, or printed circuit board traces. In some embodiments, the routings or traces on the module, interposer, or printed circuit board (PCB) can be tailored to be a part of the RF matching networks and are as small as possible to minimize the loss from the RF routings. For example, the connections can be made using solder bumps on each die placed close together. The tunable part of the output matching network associated with circuit 220 is implemented in the Process 2 die using switches. Channel tuning using circuit 220 enables a wideband power amplifier to be achieved and can also be used for the impedance control supporting multiple applications such as WLAN and blue tooth (BT) with each efficiency optimized. When a transformer is located in the module, printed circuit board, or Process 1 die (circuit 202), all or part of the balanced nodes, unbalanced node, and center taps can be routed to the tunable part (e.g., circuit 204).

Referring to FIG. 3, RF amplifier 300 includes a circuit 302 provided using Process 1 and circuit 204 provided using Process 2. Components with the same reference numeral in FIG. 3 as FIG. 2A refer to the same or similar component. Circuit 302 is similar to circuit 202 and can be provided on its own die, and circuit 204 can be provided on its own die (e.g., separate from the die of circuit 202). Circuits 302 and 204 can be provided in an IC package as a multichip module in some embodiments.

The circuitry of RF amplifier 300 is a hybrid power amplifier with RF tuning (Fixed Output Matching) on the die associated with Process 1. The multichip module can include a printed circuit board for housing circuits and providing interconnections between circuits 302 and 204. In some embodiments, RF amplifier 300 includes an output matching circuit 370 which is not outside circuit 302. Output matching circuit 370 is similar to output matching circuit 270 can include the components shown in FIG. 2C or can be similar to circuit 250 configured for output matching. Circuit 370 of circuit 302 is coupled to circuit 220 of circuit 204 at output 380.

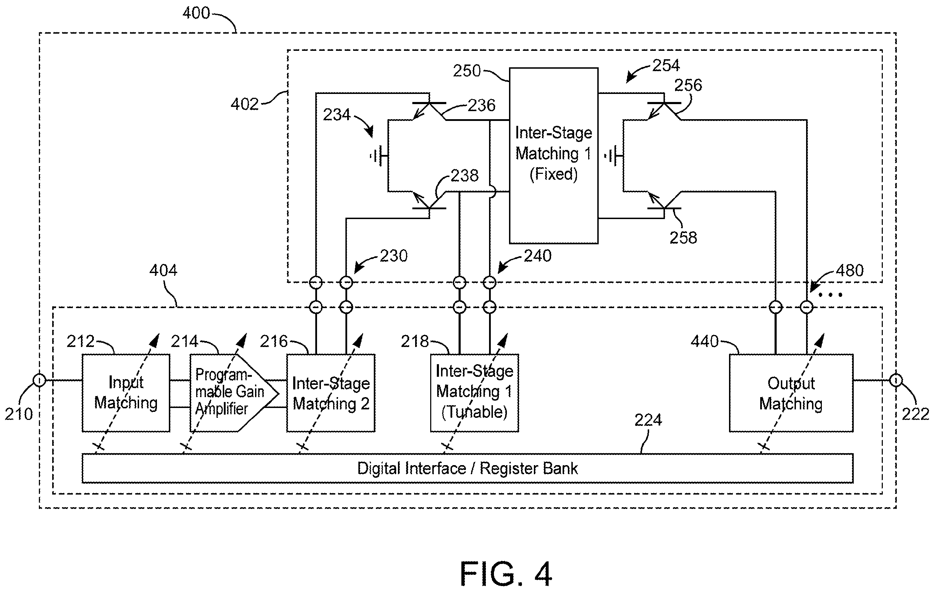

Referring to FIG. 4, RF amplifier 400 includes a circuit 402 provided using Process 1 and circuit 204 provided using Process 2. Components with the same reference numeral in FIG. 4 as FIG. 2A refer to the same or similar component. Circuit 402 is similar to circuit 202 and can be provided on its own die, and circuit 204 can be provided on its own die (e.g., separate from the die of circuit 202). Circuits 402 and 204 can be provided in an IC package as a multichip module in some embodiments.

The circuitry of RF amplifier 400 is a hybrid power amplifier with output matching provided on the die associated with Process 1. An output 480 of circuit 402 is coupled to output matching circuit 440 of circuit 404. Output 480 is coupled to transistors 258 and 256 of driver circuit 254. Output matching circuit 440 is configured to provide output matching without a fixed output matching circuit on the module or on the die associated with circuit 402.

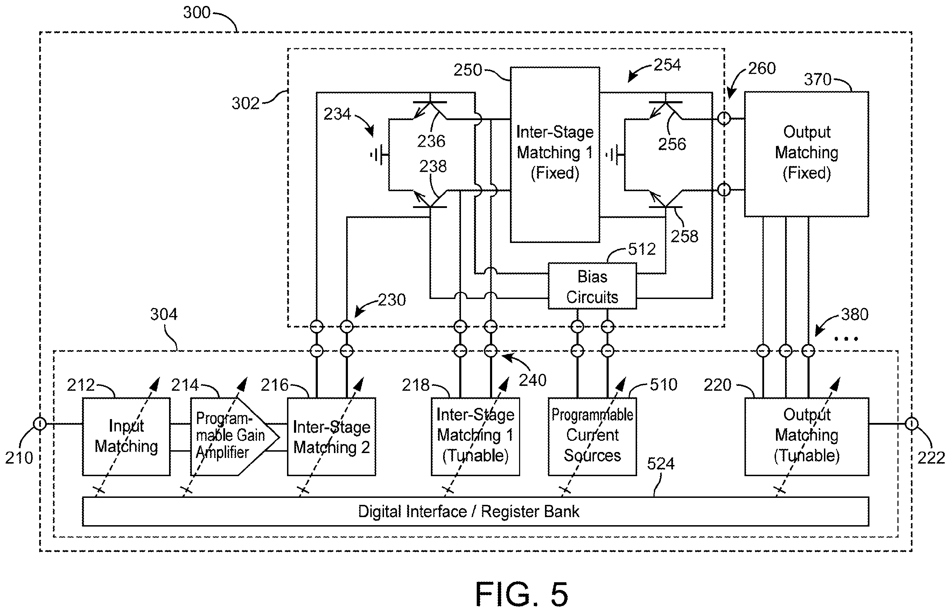

Referring to FIG. 5, RF amplifier 500 includes circuit 502 provided using Process 1 and circuit 504 provided using Process 2. Components with the same reference numeral in FIG. 5 as FIG. 2A refer to the same or similar component. Circuits 502 is similar to circuit 202 and circuit 504 is similar to circuit 204. Circuit 504 includes programmable current sources 510 coupled to bias circuits 512 of circuit 502. Bias circuits 512 provide current or voltage bias to driver circuit 234 and 254. Bias circuit 512 can affect voltage or current supplied to driver circuits 234 and 254 in some embodiments. Programmable current sources provide the current for the biasing operations of circuits 512. The bias current is configured by control signals provided via interface 524. The current from sources 510 is provided across an interface 520.

Bias circuits 512 on the die associated with Process 1 can be controlled separately by providing the variable reference currents from sources 510 on the die associated with Process 2. In some embodiments, one reference current for each amplifier stage or circuit 234 and 254 may be used but it is not so limited. This enables control of linearity and efficiency. In each application or mode, efficiency can be modified and/or optimized using the linearity-efficiency tradeoff.

Any of the embodiments of the present solution described in connection with FIGS. 2A-5 may be used in any type and form of device, such as any of the devices described in connection with FIGS. 1A-1C, such as any devices performing RF based or wireless communications, including but not limited to any communications for any IEEE standards based WiFi communications.

An integrated circuit package can refer to a unit that contains at least one integrated circuit die. An integrated circuit package can include a substrate, one or more die attached directly or indirectly to the substrate, a housing, cap, cover, encapsulation, or container for the die and input/output connectors (e.g., pins, contacts, solder balls, etc. in some embodiments). Electronic products can include or be a single die integrated circuit package or a multichip modules. The single die integrated circuit package or a multichip modules can include a power amplifier. A multichip module generally includes two or more IC die in a package. An interposer may refer to any structure that is configured to house one or more IC die and provides interconnections for the IC die in some embodiments. The interposer can be located between the die and the substrate in some embodiments. In a multichip module (MCM), an interposer is a substrate that sits between the silicon chips (or die) and the package substrate or a main circuit board in some embodiments. A die can refer to a structure including an integrated circuit in some embodiments. For example, a die can be a chip or chiplet. A chiplet or tile can refer to an IC die such as an IC dies used in a multichip module in some embodiments.

Circuitry or circuit may refer to any electronic circuit or combination of circuits. To the extent that a device, circuit, processor or circuitry is described or recited in a claims as performing one or more operations or functions or as configured to perform to one or more operations or functions, the performance of the recited function(s) or operation(s) can be distributed across two or more devices, circuits, or processors without departing from the scope of the claims unless those functions or operations are explicitly recited as being performed on a specific single circuit or set of circuits, processor, or device (e.g. using the phrase "on a single circuit", "on the set of circuits comprising" or "on a single device"). Inputs and outputs refer to inputs, outputs, input/outputs, and interfaces for bidirectional signal provision or biasing in some embodiments.

References to "or" may be construed as inclusive so that any terms described using "or" may indicate any of a single, more than one, and all of the described terms. References to at least one of a conjunctive list of terms may be construed as an inclusive OR to indicate any of a single, more than one, and all of the described terms. For example, a reference to "at least one of 'A' and 'B'" can include only 'A', only 'B', as well as both 'A' and 'B'. Such references used in conjunction with "comprising" or other open terminology can include additional items.

It should be noted that certain passages of this disclosure may reference terms such as "first" and "second" in connection with devices, mode of operation, transmit chains, etc., for purposes of identifying or differentiating one from another or from others. These terms are not intended to merely relate entities (e.g., a first device and a second device) temporally or according to a sequence, although in some cases, these entities may include such a relationship. Nor do these terms limit the number of possible entities (e.g., devices) that may operate within a system or environment. The terms coupled or connected includes indirect and direct couplings and connections.

It should be understood that the systems described above may provide multiple ones of any or each of those components and these components may be provided on either a standalone machine or, in some embodiments, on multiple machines in a distributed system. In addition, the systems and methods described above may be provided as one or more computer-readable programs or executable instructions embodied on or in one or more articles of manufacture. The article of manufacture may be a floppy disk, a hard disk, a CD-ROM, a flash memory card, a PROM, a RAM, a ROM, or a magnetic tape. In general, the computer-readable programs may be implemented in any programming language, such as LISP, PERL, C, C++, C#, PROLOG, or in any byte code language such as JAVA. The software programs or executable instructions may be stored on or in one or more articles of manufacture as object code.

While the foregoing written description of the methods and systems enables one of ordinary skill to make and use what is considered presently to be the best mode thereof, those of ordinary skill will understand and appreciate the existence of variations, combinations, and equivalents of the specific embodiment, method, and examples herein. The systems and methods should therefore not be limited by the above described embodiments, methods, and examples, but by all embodiments and methods within the scope and spirit of the disclosure. The headings provided in this document are non-limiting.

## Claims

1. A power amplifier (PA), comprising:
circuitry comprising a first die with amplification circuitry fabricated using a first integrated circuit (IC) process and a second die with amplification circuitry fabricated using a second IC process, wherein the circuitry is provided in a single package or
module, wherein the amplification circuitry fabricated using the first integrated circuit (IC) process is couped to the amplification circuitry fabricated using the second integrated circuit (IC) process using a plurality of connections within the single package or module.

2. The PA of claim 1, wherein the circuitry further comprises at least one matching circuit integrated in whole or partially using the first IC process and wherein the connections are die-to-die connections.

3. The PA of one of the previous claims, wherein the circuitry further comprises at least one matching circuit integrated in whole or partially in the second IC process and wherein the connections comprise an interstage connection.

4. The PA of one of the previous claims, wherein the circuitry further comprises at least one matching circuit integrated in whole or partially on a module substrate
and/or
wherein the circuitry further comprises at least one matching circuit integrated in whole or partially on a printed-circuit board substrate.

5. The PA of one of the previous claims, wherein controls on the first die can be used to tune matching circuits implemented on the first die, the second die, a module substrate or a printed circuit board substrate,
in particular,
wherein the circuitry further comprises switch capacitors configured to tune at least one matching circuit.

6. The PA of one of the previous claims, wherein an output matching circuit is integrated in the first die
and/or
further comprising an output matching circuit integrated in the second die and directly coupled to a driver circuit on the first die.

7. A multichip module, comprising:
a first die comprising a driver circuit, the driver circuit being fabricated using a first process different than a second process; and
a second die comprising configurable impedance matching circuit, the impedance matching circuit being fabricated using the second process, wherein the first die and the second die are provided in a single package or module, wherein the amplification circuitry fabricated using the first integrated circuit (IC) process is couped to the amplification circuitry fabricated using the second integrated circuit (IC) process using a plurality of connections within the single package or module.

8. The multichip module of claim 7, wherein the first process is a gallium arsenide or silicon germanium process and the second process is a complementary metal oxide semiconductor process.

9. The multichip module of claims 7 or 8, wherein the driver circuit comprises a first stage and a second stage, wherein a first interstage impedance matching circuit is coupled between the first stage and the second stage and is disposed on the first die, in particular,
wherein the first interstage impedance matching circuit is a fixed circuit.

10. The multichip module of claim 9, further comprising a pair of second interstage impedance matching circuits disposed on the second die, wherein the first stage is disposed between the pair of the second interstage impedance matching circuits.

11. The multichip module of one of claims 7 to 10, wherein the first die comprises a bias circuit and the second die comprises a current source for the bias circuit.

12. The multichip module of one of claims 7 to 11, further comprising an output impedance matching circuit disposed on the first die.

13. A method, comprising:
providing an RF signal to a second die with amplification circuitry fabricated in a second integrated circuit (IC) process; and
providing the RF signal to a first die with amplification circuitry fabricated in a first integrated circuit (IC) process, wherein the first die and second die are provided in a single package or module, wherein the amplification circuitry fabricated using the first integrated circuit (IC) process is couped to the amplification circuitry fabricated using the second integrated circuit (IC) process using a plurality of connections within the single package or module.

14. The method of claim 13, further comprising:
providing the RF signal to a first matching circuit on the second die;
providing the RF signal to a first driver circuit on the first die; and
providing the RF signal to a first output coupled to a second matching circuit disposed on the second die and a third matching circuit disposed on the first die
and/or
providing the RF signal to a second driver circuit on the first die.

15. The method of claim 14, further comprising:
providing the RF signal to a fourth impedance matching circuit on the first die, on a printed circuit board, on an interposer, or on a package substrate.
